# EUROPÄISCHE PATENTSCHRIFT

(11) **EP 1 147 694 B1**
(45) Veröffentlichungstag und Bekanntmachung des Hinweises auf die Patenterteilung: **06.08.2003**
(21) Anmeldenummer: 99962062.8
(22) Anmeldetag: 19.11.1999
(51) Int. Cl.: H05K 5/06

(54) **ELEKTRONIKMODUL**
ELECTRONIC MODULE
MODULE ELECTRONIQUE

(30) Priorität: 23.12.1998 DE 19860035
(43) Veröffentlichungstag der Anmeldung: 24.10.2001
(73) Patentinhaber: TRW Automotive Electronics & Components GmbH & Co. KG, 78315 Radolfzell (DE)
(72) Erfinder: WOHLFAHRT, Karl-Heinz, D-78315 Radolfzell (DE); SINGER, Horst, D-78315 Radolfzell (DE)
(74) Vertreter: Eder, Thomas, Dr.-Ing.
(86) Internationale Anmeldenummer: DE9903691
(87) Internationale Veröffentlichungsnummer: WO00040066

(56) Entgegenhaltungen:
- EP-A- 0 414 138
- EP-A- 0 473 242
- EP-A- 0 832 936
- DE-A- 3 702 782
- US-A- 4 546 412

## Beschreibung

Die Erfindung betrifft ein Elektronikmodul, insbesondere für die Kfz-Technik, sowie ein Aufnahmeelement mit einem darin integrierten Elektronikmodul.

Um beispielsweise die korrekte Verriegelung eines Gurtschlosses eines Rückhaltesystems in einem Kfz zu überprüfen, ist es bekannt, mittels eines Endschalters im Gurtschloss die Verriegelungsstellung des in das Schloss eingeschobenen Verriegelungsteils des Gurts zu erfassen. Hierdurch ist überwachbar, ob die betreffende Person den Gurt korrekt geschlossen hat und es kann im Bedarfsfall ein Fehler- oder Anforderungssignal erzeugt werden.

In jüngerer Zeit wurde in der Kfz-Technik jedoch die Forderung laut, dass zur Erhöhung der Sicherheit eines Kfz auch Fehlfunktionen einer Vorrichtung zur Überwachung der Verriegelungsstellung eines Gurtschlosses erkannt werden müssen. Dies ist beispielsweise insbesondere dann erforderlich, wenn die von einer derartigen Vorrichtung gelieferte Information zur Ansteuerung eines oder mehrerer Airbags verwendet wird. Beispielsweise ist es möglich, den Airbag zeitlich oder hinsichtlich seines Füllgrads oder seiner Füllgeschwindigkeit anders anzusteuern, je nachdem, ob die zu schützende Person angeschnallt ist oder nicht.

Eine derartige Vorrichtung erfordert üblicherweise den Einsatz einer entsprechenden Elektronik.

Der Einbau einer derartigen Elektronik in ein Gurtschloss eines Gurtsystems eines Kfz ist jedoch mit der Schwierigkeit verbunden, dass die Elektronik auf engstem Raum in das Gurtschloss integriert werden muss und dennoch sichergestellt sein muss, dass die Elektronik innerhalb des Gurtschlosses ausreichend vor im Kfz auftretenden Vibrationen, mechanischen Schocks und anderen Umwelteinflüssen geschützt ist.

Im Stand der Technik nach der EP-A-0 473 242 ist es bekannt, einen Elektronikbaustein innerhalb eines Schutzgehäuses gegen mechanische und chemische Umwelteinflüsse dadurch zu sichern, dass das Schutzgehäuse ein den Elektronikbaustein enthaltendes gummielastisches Innengehäuse und ein das Innengehäuse mit Druck umgebendes Außengehäuse umfasst. Das Innengehäuse besteht insbesondere aus einem quaderförmigen Mittelteil mit je einem deckelartigen Ober- und Unterteil. Durch die Kombination eines gummielastischen Innengehäuses und eines harten Außengehäuses, welches das Innengehäuse mit Druck umgibt, wird die Feuchtigkeitsabdichtung erreicht.

Der Erfindung liegt daher die Aufgabe zugrunde, ein Elektronikmodul zu schaffen, welches bei kraftschlüssiger oder formschlüssiger Integration in ein Aufnahmeteil ausreichend vor Vibrationen und mechanischen Schocks sowie anderen Umwelteinflüssen geschützt ist. Die Herstellung eines derartigen Elektronikmoduls soll mit möglichst geringem Aufwand erfolgen können. Des Weiteren soll mit der vorliegenden Erfindung ein Aufnahmeelement mit einem derartigen Elektronikmodul, insbesondere ein Gurtschloss für einen Haltegurt, geschaffen werden, das den vorstehend erwähnten Anforderungen genügt

Die Erfindung löst diese Aufgabe mit den Merkmalen der Patentansprüche 1 bzw. 5.

Durch das erfindungsgemäße Umgeben der elektrischen Leiterzüge und der elektronischen oder elektromechanischen Bauelemente mit einem Kunststoff geringer Shorehärte wird eine elastische Hülle hergestellt, welche das Elektronikmodul vor Umwelteinflüssen schützt und welche ggf. die elektronischen Bauelemente und die Leiterzüge erst zu einem Modul zusammenfasst. Zudem kann durch diese weiche Hülle gewährleistet werden, dass bei einer kraftschlüssigen oder formschlüssigen Integration des Elektronikmoduls in ein Aufnahmeelement Vibrationen und mechanische Schocks nur gedämpft auf die Leiterzüge, die Bauelemente und insbesondere auf die Verbindungsstellen der Bauelementanschlüsse mit den Leiterzügen übertragen werden. Das Modul wird somit hinreichend vor einer mechanischen Zerstörung geschützt.

Das Umgeben der Leiterzüge und Bauelemente mit dem relativ weichen Kunststoff, der vorzugsweise eine Shorehärte kleiner oder gleich 60 Shore, vorzugsweise zwischen 25 und 60 Shore, am vorteilhaftesten zwischen 40 und 60 Shore aufweist, kann auf relativ einfache und kostengünstige Weise durch Umspritzen erfolgen.

Die Bauelemente können beispielsweise auf einem Stanzgitter oder einer gedruckten Leiterplatte angeordnet sein. Für den Fall, dass ein Stanzgitter verwendet wird, gewährleistet die Umhüllung mit dem relativ weichen Kunststoff gleichzeitig eine ausreichende Fixierung der Leiterzüge und der Bauelemente, wobei das so beschaffene Modul noch mechanisch labil, aber elektrisch voll funktionsfähig ist.

Die Kunststoffumhüllung kann so geformt sein, dass zumindest Teile davon zur einfachen kraftschlüssigen und/oder formschlüssigen Verbindung mit einem Aufnahmeteil ausgebildet sind. Beispielsweise kann die Kunststoffumhüllung Vorsprünge aufweisen, mit welchen das Modul sicher in dem Aufnahmeteil gehalten werden kann.

Nach einer Ausführungsform der Erfindung kann die relativ weiche Kunststoffumhüllung zusätzlich mit einem Mantel aus starrem Kunststoff umgeben, vorzugsweise umspritzt sein. Hierdurch wird das - zumindest im Fall der Ausbildung der Leiterzüge als Stanzgitter - mechanisch labile Elektronikmodul stabilisiert. Insbesondere kann hierdurch eine einfache Montage des Moduls in einem Aufnahmeteil gewährleistet werden, beispielsweise durch Rastverbindungen, Verschweißen, beispielsweise Ultraschallschweißen, Schrauben oder dergleichen.

In einer anderen Ausführungsform der Erfindung kann ein Aufnahmeelement mit einem entsprechend integrierten Elektronikmodul auch dadurch geschaffen werden, dass das Elektronikmodul lediglich mit seiner relativ weichen Kunststoffumhüllung in ein Aufnahmeelement eingespritzt oder eingegossen wird. Hierdurch erfolgt, ebenso wie bei der Montage eines Moduls mit zusätzlicher starker Kunststoffumhüllung eine flexible bzw. federnde Lagerung des Elektronikmoduls in dem Aufnahmeelement.

Zusätzlich kann das Elektronikmodul, falls erforderlich bzw. vorteilhaft auch an einer oder mehreren Stellen unmittelbar mit seinen Leiterzügen bzw. der gedruckten Leiterplatte im Aufnahmeelement fixiert sein, wobei diese Fixierung selbstverständlich nicht soweit gehen darf, dass die Leiterzüge insgesamt vollkommen starr im Modul gehalten sind. Auch in diesem Fall muss eine ausreichende federnde bzw. gedämpfte federnde Lagerung der wesentlichen Teile der Elektronik, insbesondere der elektronischen Bauelemente des Elektronikmoduls gewährleistet sein.

Weitere Ausführungsformen der Erfindung ergeben sich aus den Unteransprüchen.

Die Erfindung wird nachfolgend anhand in der Zeichnung näher erläuterten Ausführungsbeispiele beschrieben. In der Zeichnung zeigen:
- Fig. 1: ein Elektronikmodul, bestehend aus Leiterzügen in Form eines Stanzgitters und darauf vorgesehenen elektronischen Bauelementen;
- Fig. 2: das Elektronikmodul in Fig. 1, jedoch umspritzt mit einem Kunststoffmaterial geringer Shorehärte;
- Fig. 3: ein Elektronikmodul entsprechend Fig. 2, jedoch zusätzlich umspritzt mit einer Umhüllung aus starrem Kunststoff und
- Fig. 4: ein Aufnahmeelement in Form einer offenen Halbschale eines Gurtschlosses für ein Kfz.

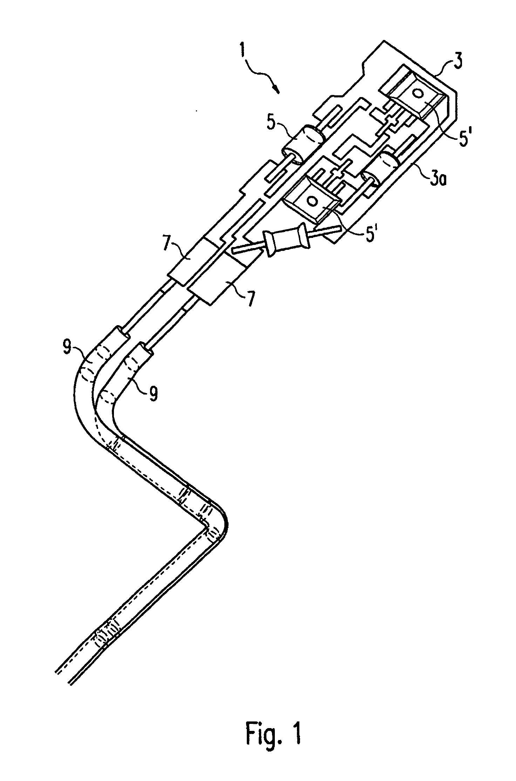

Das in Fig. 1 perspektivisch dargestellte Elektronikmodul 1 besteht im Wesentlichen aus einzelnen Leiterzügen 3a eines Stanzgitters 3, auf welchem elektronische und/oder elektromechanische Bauelemente 5 vorgesehen sind. Beispielsweise zeigt Fig. 1 zwei auf dem Stanzgitter 3 vorgesehene Hall-Elemente 5' die als Positionsdetektoren für ein zu erfassendes Verriegelungsteil eines Gurtsystems für ein Kfz dienen können.

Das Elektronikmodul 1 weist Anschlusskontakte 7 auf, welche von elektrischen Leitern von elektrischen Anschlussleitungen 9 kontaktiert werden.

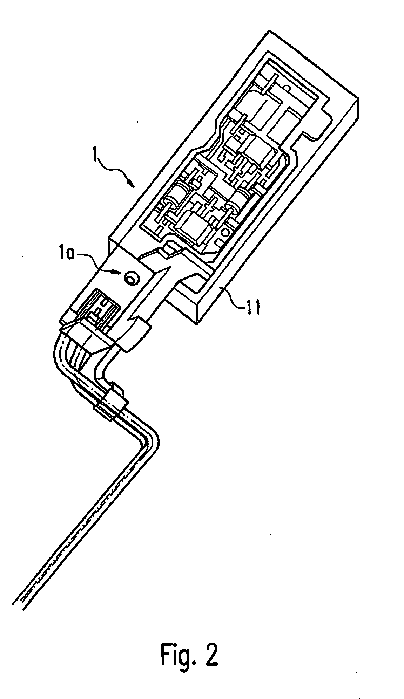

Fig. 2 zeigt das Elektronikmodul in Fig. 1, jedoch zusätzlich ummantelt mit einer Hülle 11, bestehend aus einem Kunststoff geringer Shorehärte. Die Shorehärte des Kunststoffs liegt vorzugsweise in einem Bereich zwischen 40 und 60 Shore.

Wie in Fig. 2 dargestellt, kann die Hülle 11 aus relativ weichem Kunststoff den gesamten vorderen Bereich des Elektronikmoduls 1 umgeben. Die Schicht überhalb der Hall-Elemente 5' muss selbstverständlich so beschaffen sind, dass die Hall-Elemente das zu detektierende Verriegelungsteil, an welchem mindestens ein Magnet vorgesehen ist, noch erfassen können.

Werden anstelle der Hall-Elemente beispielsweise optische Sensoren eingesetzt, so ist es erforderlich, einen für die betreffende Lichtwellenlänge ausreichend transparenten Kunststoff zu verwenden.

Durch die Umhüllung des Stanzgitters 3 mit dem relativ weichen Kunststoff erfolgt zwar eine zur weiteren Montage des so hergestellten Elektronikmoduls ausreichende mechanische Fixierung, jedoch ist das mit dem weichem Kunststoff umgebene Elektronikmodul 1 immer noch relativ labil,

Das Aufbringen der relativ weichen Kunststoffschicht kann beispielsweise durch Umspritzen des Elektronikmoduls 1 erfolgen, wobei zumindest diejenigen Bereiche des Elektronikmoduls mit der Kunststoffschicht umgeben werden sollten, die die elektronischen und/oder elektromechanischen Bauelemente beinhalten. Der in Fig. 2 umspritzt dargestellte Bereich 1a des Elektronikmoduls 1 in der Umgebung der Anschlusskontakte 7 für die Anschlussleitungen 9 kann auch frei bleiben, beispielsweise um in diesen Bereich eine Steckverbindung für mit entsprechenden Steckverbindern oder Buchsen versehene Anschlussleitungen vorzusehen.

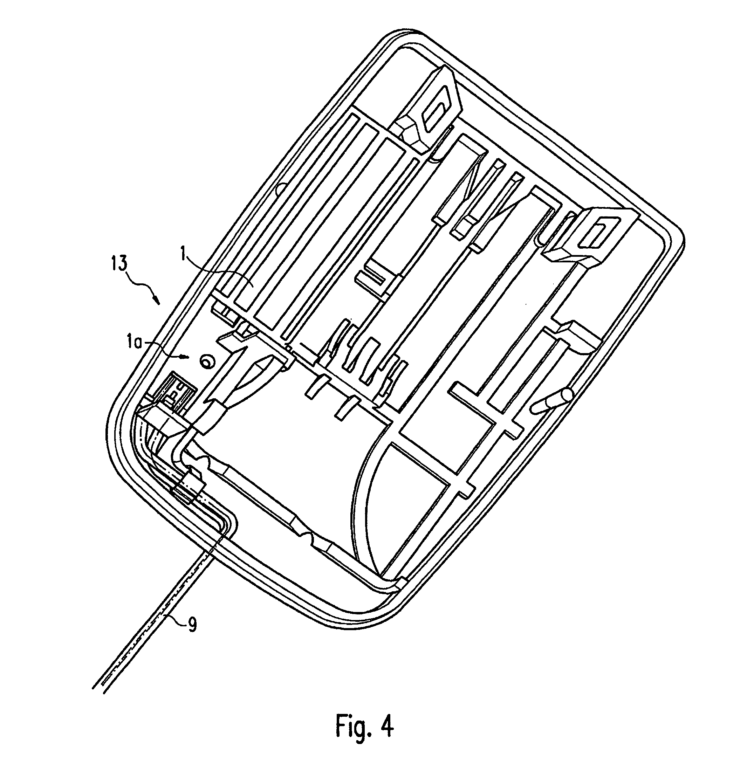

Fig. 4 zeigt ein Aufnahmeelement 13 in Form einer Halbschale für ein Gurtschloss eines Gurtsystems für ein Kfz, wobei ein mit einer relativ weichen Kunststoffschicht umspritztes Elektronikmodul 1 gemäß Fig. 2 in das Aufnahmeelement integriert wurde. Das Herstellen des Aufnahmeelements 13 mit integriertem Elektronikmodul 1 kann beispielsweise durch ein unmittelbares Umspritzen des mit weichem Kunststoff umgebenen Elektronikmoduls 1 erfolgen.

Das Fixieren bzw. Halten des Elektronikmoduls 1 im Aufnahmeelement 13 kann in der Weise erfolgen, dass das Elektronikmodul 1 so in das Aufnahmeelement eingespritzt ist, dass ausschließlich die Hülle 11 aus weichem Kunststoff von dem starren Kunststoff des Aufnahmeelements 13 umgeben ist. Hierdurch erfolgt insgesamt eine federnde, stoßgedämpfte Lagerung des Elektronikmoduls 1 im Aufnahmeelement 13.

Falls erforderlich, kann das Elektronikmodul zusätzlich an einem oder mehreren Bereichen vom starren Material des Aufnahmeelements 13 umgeben sein. In diesem Fall muss jedoch gewährleistet werden, dass zumindest die gegen Vibrationen und mechanische Schocks zu schützenden Teile des Elektronikmoduls 1 noch federnd aber stoßgedämpft gelagert sind. Beispielsweise könnte der Bereich 1a des Elektronikmoduls 1 noch zusätzlich starr im Aufnahmeelement 13 verankert sein.

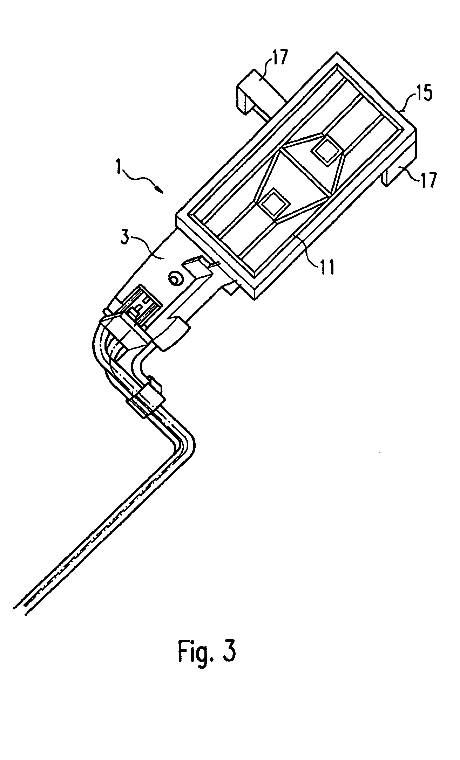

In Fig. 3 ist eine weitere Variante eines erfindungsgemäßen Elektronikmoduls 1 dargestellt. Zur Herstellung des in Fig. 3 dargestellten Moduls wurde zunächst ein Modul wie in Fig. 2 hergestellt, das heißt, das Modul 1 in Fig. 1 wurde zunächst mit einer Hülle 11 aus Kunststoffmaterial geringer Shorehärte umgeben. Zusätzlich wurde bei dem in Fig. 3 dargestellten Elektronikmodul die Hülle 1 aus weichem Kunststoff mit einer Hülle 15 aus starrem Kunststoffmaterial umspritzt. Das Umspritzen kann nur in Teilbereichen oder über den gesamten Umfang erfolgen. Eine Verbindung der starren Hülle 15 mit dem Stanzgitter 3 bzw. den Bauelementen 5 sollte zumindest weitestgehend vermieden werden, um eine federnde, gedämpfte Lagerung des Elektronikmoduls zu ermöglichen.

An der starren Hülle 15 können Elemente 17 zur Montage des Elektronikmoduls 1 in einem Aufnahmeelement vorgesehen sein. Hierbei kann es sich beispielsweise um Rastelemente handeln oder solche Elemente, die durch Schweißen, beispielsweise Ultraschallschweißen mit entsprechenden Bereichen des Aufnahmeelements verbunden werden können. Das erfindungsgemäße Elektronikmodul gewährleistet somit die Möglichkeit einer äußerst raumgedrängten und dennoch stoß- und vibrationsgeschützten Montage in einem Aufnahmeelement. Das Element kann dabei entsprechend vorgefertigt und in dem dann bereits gegen mechanische Beschädigungen und Erschütterungen geschützten Zustand gelagert und in das Aufnahmeelement integriert werden. Zusätzlich zu dem rein mechanischen Schutz gegen Vibrationen und Stöße gewährleistet die Umhüllung mit dem weichen bzw. dem weichen und zusätzlich harten Kunststoff einen Schutz gegen andere Umwelteinflüsse, beispielsweise Feuchtigkeit, Korrosion und dergleichen. Als Material für die weiche Kunststoffschicht eignet sich ein Elastomer mit entsprechenden Eigenschaften.

Selbstverständlich kann ein derartiges Elektronikmodul nicht nur in der Kfz-Technik und insbesondere in Verbindung mit Gurtschlössern für ein Kfz Verwendung finden, sondern in allen Fällen, in denen eine stoß- und vibrationsgeschützte Integration auf engstem Raum in ein entsprechendes Aufnahmeteil erforderlich ist.

## Patentansprüche

1. Elektronikmodul, bestehend aus elektrischen Leiterzügen (3a), einem oder mehreren elektronischen und/oder elektromechanischen Bauelementen (5, 5') und einem oder mehreren elektrischen Anschlusskontakten (7),
a) wobei die Leiterzüge (3a) und die Bauelemente (5, 5') zu deren stoßgedämpfter Lagerung zumindest teilweise mit einem weichen Kunststoff (11) umhüllt sind, und
b) dass das Modul (1) zumindest im Bereich der Kunststoffumhüllung (11) mit einem starren Kunststoff (15) umspritzt ist.

2. Elektronikmodul nach Anspruch 1, **dadurch gekennzeichnet, dass** das Umhüllen der Leiterzüge (3a) und Bauelemente (5, 5') mit dem Kunststoff (11) durch Umspritzen erfolgt ist.

3. Elektronikmodul nach einem der vorhergehenden Ansprüche, **dadurch gekennzeichnet, dass** die Bauelemente (5, 5') auf einem Stanzgitter (3) oder einer gedruckten Leiterplatte angeordnet sind.

4. Elektronikmodul nach einem der vorhergehenden Ansprüche, **dadurch gekennzeichnet, dass** das mit dem weichen Kunststoff (11) umhüllte Modul (1) mechanisch labil ist.

5. Aufnahmeelement, insbesondere Gurtschloss für einen Haltegurt, mit einem Elektronikmodul nach einem der vorhergehenden Ansprüche, **dadurch gekennzeichnet, dass** das Elektronikmodul (1) zumindest im Bereich der Kunststoffumhüllung (11) oder im Bereich der starren Kunststoffumhüllung im Aufnahmeelement (13) kraftschlüssig oder formschlüssig gehalten ist

6. Aufnahmeelement nach Anspruch 5, **dadurch gekennzeichnet, dass** das Elektronikmodul (1) mit seiner Kunststoffumhüllung (11) oder seiner starren Kunststoffumhüllung (13) in das Aufnahmeelement eingespritzt ist.

7. Aufnahmeelement nach Anspruch 5 oder 6, **dadurch gekennzeichnet, dass** das Elektronikmodul zusätzlich zur kraflschlüssigen oder formschlüssigen Halterung in einem Bereich des Stanzgitters oder der gedruckten Leiterplatte kraftschlüssig oder formschlüssig gehalten ist.

## Claims

1. Electronic module, composed of electrical lines (3a), one or more electronic and/or electromechanical components (5, 5') and one or more electrical connecting contacts (7),
a) the lines (3a) and the components (5, 5') being at least partially sheathed by a soft plastic (11) in order to support them in a shock-absorbing fashion, and
b) the module (1) being encapsulated by injection moulding using a rigid plastic (15), at least in the region of the plastic sheath (11).

2. Electronic module according to Claim 1, **characterized in that** the sheathing of the lines (3a) and components (5, 5') is carried out by means of encapsulation by injection moulding using the plastic (11).

3. Electronic module according to one of the preceding claims, **characterized in that** the components (5, 5') are arranged on a punched grille (3) or a printed circuit board.

4. Electronic module according to one of the preceding claims, **characterized in that** the module (1) which is sheathed with the soft plastic (11) is mechanically pliable.

5. Receptacle element, in particular belt lock for a restraining belt, having an electronic module according to one of the preceding claims, **characterized in that** the electronic module (1) is secured in a frictionally locking or positively locking fashion in the receptacle element (13) at least in the region of the plastic sheath (11) or in the region of the rigid plastic sheath.

6. Receptacle element according to Claim 5, **characterized in that** the electronic module (1) is encapsulated in the receptacle element by injection moulding using its plastic sheath (11) or its rigid plastic sheath (13).

7. Receptacle element according to Claim 5 or 6, **characterized in that**, in order to secure it in a frictionally locking or positively locking fashion, the electronic module is additionally secured in a frictionally locking or positively locking fashion in a region of the punched grille or of the printed circuit board.

## Revendications

1. Module électronique, constitué par des voies conductrices électriques (3a), un ou plusieurs composants électroniques et/ou électromécaniques (5, 5') et un ou plusieurs contacts de raccordement électrique (7), dans lequel
a) les voies conductrices (3a) et les composants (5, 5') sont enveloppés au moins partiellement par une matière synthétique souple (11), pour être supportés avec amortissement contre les chocs, et
b) le module (1) est enrobé par injection par une matière synthétique rigide (15), au moins dans la zone de l'enveloppe en matière synthétique (11).

2. Module électronique selon la revendication 1, **caractérisé en ce que** l'enveloppement des voies conductrices (3a) et des composants (5, 5') est réalisé par enrobage par injection avec la matière synthétique (11).

3. Module électronique selon l'une des revendications précédentes, **caractérisé en ce que** les composants (5, 5') sont disposés sur une grille estampée (3) ou sur une plaquette à circuits imprimés.

4. Module électronique selon l'une des revendications précédentes, **caractérisé en ce que** le module (1) enveloppé par la matière synthétique souple (11) est instable mécaniquement.

5. Elément de réception, notamment verrou de ceinture pour une ceinture de retenue, comportant un module électronique selon l'une des revendications précédentes, **caractérisé en ce que** le module électronique (1) est retenu selon une liaison de force ou selon une liaison par formes complémentaires au moins dans la zone de l'enveloppe en matière synthétique (11) ou dans la zone de l'enveloppe rigide en matière synthétique dans l'élément de réception (13).

6. Elément de réception selon la revendication 5, **caractérisé en ce que** le module électronique (1) est moulé par injection avec son enveloppe en matière synthétique (11) ou son enveloppe en matière synthétique rigide (13) dans l'élément de réception.

7. Elément de réception selon la revendication 5 ou 6, **caractérisé en ce que** le module électronique est retenu, en plus de son maintien selon une liaison de force ou selon une liaison par formes complémentaires, dans une zone de la grille estampée ou de la plaquette à circuits imprimés selon une liaison de force ou selon une liaison par formes complémentaires.
